# DEMANDE DE BREVET EUROPEEN

(11) **EP 0 767 387 A1**
(43) Date de publication de la demande: **09.04.1997**
(21) Numéro de dépôt: 96402082.0
(22) Date de dépôt: 01.10.1996
(51) Int. Cl.: G01R 13/22

(54) **Procédé et dispositif pour l'utilisation en mode normal d'un oscilloscope différentiel**

(30) Priorité: 02.10.1995 FR 9511566
(71) Demandeur: METRIX, 74943 Annecy-le-Vieux (FR)
(72) Inventeur: Tobarias, José, La Mollière, 74150 Marcellaz Albanais (FR)
(74) Mandataire: Kohn, Philippe

(57) **Abrégé**

L'invention concerne un procédé pour l'utilisation en mode normal d'un oscilloscope différentiel comportant, pour chaque voie, un étage amplificateur d'entrée (9) recevant les deux signaux dont on veut visualiser la différence par l'intermédiaire de deux circuits atténuateurs à haute impédance (11) reliés respectivement à deux bornes d'entrée négative et positive (3, 4), caractérisé en ce que l'on déconnecte l'une des entrées (13) de l'étage amplificateur d'entrée (9) et on la relie à la masse et on agit sur le circuit atténuateur (11) correspondant de manière à maintenir la même impédance d'entrée sur la borne d'entrée correspondante (3).

L'invention concerne également un dispositif pour la mise en oeuvre de ce procédé.

## Description

La présente invention concerne les oscilloscopes et, plus particulièrement, les oscilloscopes différentiels.

Les oscilloscopes traditionnels d'usage courant visualisent, pour chaque voie, un signal qui leur est appliqué par l'intermédiaire d'une borne d'entrée du type blindé.

On utilise aussi, plus rarement, pour des utilisations particulières telles que la surveillance ou la mesure des réseaux d'énergie électriques, des oscilloscopes différentiels qui visualisent, pour chaque voie, la différence entre deux signaux appliqués respectivement à deux bornes d'entrées négative et positive. L'oscilloscope différentiel comporte, pour chaque voie, un étage amplificateur d'entrée recevant les deux signaux dont on veut visualiser la différence par l'intermédiaire de deux circuits atténuateurs à haute impédance reliés respectivement aux deux bornes d'entrée négative et positive.

Les deux types d'oscilloscopes correspondent à deux modes d'utilisation différents et on est donc amené, pour certaines applications, à utiliser un oscilloscope de chaque type, ce qui nécessite l'utilisation de deux appareils et complique le mode opératoire.

Par ailleurs, pour des raisons économiques, il est souhaitable de disposer d'un oscilloscope pouvant fonctionner à la fois en mode normal traditionnel et en mode différentiel.

Le problème à la base de l'invention est de fournir un oscilloscope pouvant fonctionner dans les deux modes, le passage d'un mode à l'autre s'effectuant par simple commutation interne à l'oscilloscope sans modifier le montage de mesure.

A cet effet, l'invention a pour objet un procédé pour l'utilisation en mode normal d'un oscilloscope différentiel comportant, pour chaque voie, un étage amplificateur d'entrée recevant les deux signaux dont on veut visualiser la différence par l'intermédiaire de deux circuits atténuateurs à haute impédance reliés respectivement à deux bornes d'entrée négative et positive, caractérisé en ce que l'on déconnecte l'une des entrées de l'étage amplificateur d'entrée et on la relie à la masse, et on agit sur le circuit atténuateur correspondant de manière à maintenir la même impédance d'entrée sur la borne d'entrée correspondante.

De ce fait, on élargit le domaine d'application des oscilloscopes différentiels à celui des oscilloscopes traditionnels, si bien qu'il n'est plus nécessaire de disposer de deux oscilloscopes pour toutes les utilisations possibles.

Dans le cas d'une utilisation en mode différentiel, il est possible de travailler en mode normal par simple commutation de l'appareil. Par exemple, dans le cas de mesures sur un réseau d'énergie électrique, on peut visualiser sur le même oscilloscope une tension composée entre phases et une tension simple.

Selon une autre caractéristique de l'invention, le mode de fonctionnement est commandé par un organe de commande disposé sur la face avant de l'oscilloscope.

Selon encore une autre caractéristique de l'invention, on affiche le mode de fonctionnement sur la face avant de l'oscilloscope.

De cette manière, si l'on effectue à la fois des mesures normales et des mesures différentielles, on peut savoir à tout moment le mode utilisé et, par suite, quel est le signal visualisé.

L'invention a aussi pour objet un dispositif pour la mise en oeuvre du procédé selon l'invention, caractérisé en ce qu'il comporte un organe de commande disposé sur la face avant de l'oscilloscope et relié à un circuit de génération d'un signal de commande qui est relié, pour chaque voie, à un circuit de commande relié à l'étage amplificateur d'entrée et à l'un des deux circuits atténuateurs à haute impédance.

Avantageusement, le signal de commande est un code numérique et l'organe de commande est une touche à impulsions.

Selon une autre caractéristique de l'invention, le dispositif comporte un dispositif d'affichage du mode d'utilisation, disposé sur la face avant de l'oscilloscope et relié au circuit de commande.

D'autres caractéristiques et avantages de l'invention ressortiront de la description qui suit, faite à titre illustratif et nullement limitatif, en se référant aux dessins annexés dans lesquels :
- la figure 1 représente schématiquement la face avant d'un oscilloscope différentiel selon la présente invention ; et
- la figure 2 est le schéma synoptique d'une partie de l'oscilloscope de la figure 1.

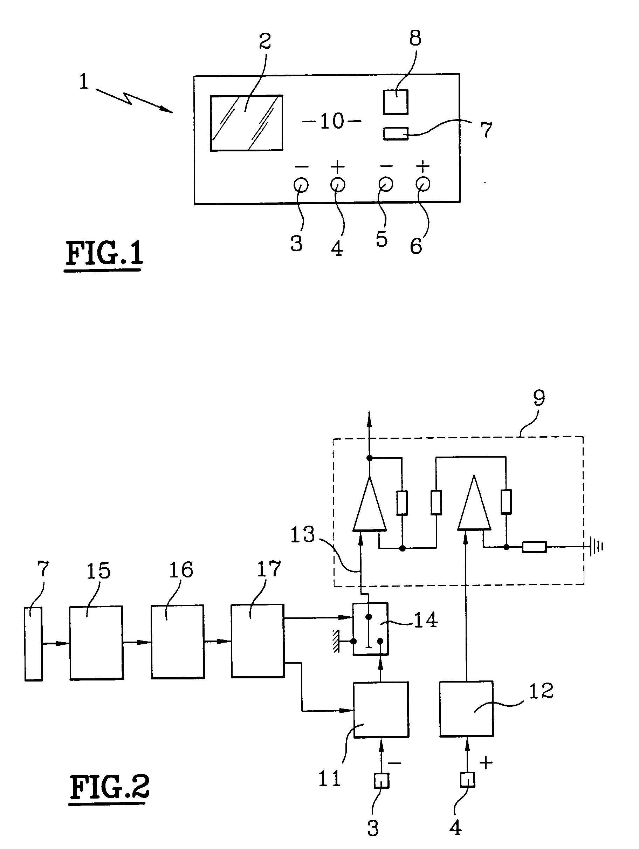

On voit sur la figure 1 la face avant d'un oscilloscope différentiel 1 à deux voies qui comporte sur sa face avant 10, de manière usuelle, un écran 2 et des bornes d'entrée négative et positive 3 et 4, respectivement 5 et 6, pour chacune des deux voies.

La face avant 10 comporte aussi un organe de commande, tel qu'une touche à impulsions 7, et un dispositif d'affichage lumineux 8 dont le fonctionnement sera décrit par la suite.

La figure 2 représente une partie du circuit électronique de l'oscilloscope différentiel 1 associée à une voie de mesure. Il comporte, de manière usuelle, les bornes d'entrée 3 et 4 qui sont reliées respectivement aux entrées d'un amplificateur différentiel d'entrée 9 par l'intermédiaire de deux circuits atténuateurs à haute impédance 11 et 12.

Entre l'une des entrées de l'amplificateur différentiel d'entrée 9, l'entrée négative 13 dans l'exemple représenté, et la sortie du circuit atténuateur 11 relié à la borne négative 3 est branché un commutateur 14 qui permet de relier l'entrée 13 de l'amplificateur différentiel d'entrée 9 soit à la sortie du circuit atténuateur 11, soit à la masse de l'oscilloscope différentiel 1.

On voit sur cette figure 2 la touche à impulsions 7 qui est reliée à un circuit électronique 15 qui génère un code numérique de commande en fonction de la lecture de l'état (appuyé ou relâché) de la touche à impulsions 7. Ce code numérique est transmis, par l'intermédiaire d'un circuit de transmission série 16, à un circuit de commande 17 dont la sortie est reliée au commutateur 14 et au circuit atténuateur 11;

Le fonctionnement de l'oscilloscope différentiel selon la présente invention est le suivant. On applique, pour chaque voie, deux signaux dont on veut visualiser la différence. Ainsi, pour la voie représentée sur la figure 2, on affiche la différence entre le signal appliqué sur la borne d'entrée positive 4 et le signal appliqué sur la borne négative 3.

Si l'on actionne la touche à impulsions 7, le circuit électronique 15 génère un code numérique qui est transmis au circuit de commande 17. Ce dernier décode le code numérique reçu et fournit des signaux de commande pour le commutateur 14 et le circuit atténuateur 11.

Le commutateur 14 déconnecte l'entrée 13 de l'amplificateur différentiel d'entrée 9 de la sortie du circuit atténuateur 11 et la relie à la masse de l'oscilloscope.

Par ailleurs, le circuit atténuateur 11 est commandé de manière à maintenir la même impédance élevée, par exemple un mégohm, du côté utilisateur , c'est-à-dire sur la borne d'entrée négative 3. L'oscilloscope affiche alors sur l'écran 2 le signal appliqué sur la borne d'entrée positive 4 et fonctionne donc comme un oscilloscope traditionnel. Le dispositif d'affichage lumineux 8 indique le mode de fonctionnement normal.

Si l'on actionne de nouveau la touche à impulsions 7, cela est détecté par circuit électronique 15 et le circuit de commande 17 commande le commutateur 14 et le circuit atténuateur 11 pour revenir au mode différentiel, l'entrée négative 13 de l'amplificateur différentiel d'entrée 9 étant de nouveau reliée à la borne d'entrée négative 3 pour réaliser la visualisation de la différence entre le signal appliqué sur la borne positive 4 et le signal appliqué sur la borne négative 3.

On voit que l'invention permet d'utiliser un seul oscilloscope pour les deux modes d'utilisation, différentiel et normal, le passage d'un mode à l'autre s'effectuant très simplement et rapidement par une commutation interne dans l'oscilloscope. On peut donc économiser le prix d'un oscilloscope traditionnel. De plus, on peut effectuer des mesures dans les deux modes sans modifier le branchement de mesure.

## Revendications

1. Procédé pour l'utilisation en mode normal d'un oscilloscope différentiel (1) comportant, pour chaque voie, un étage amplificateur d'entrée (9) recevant les deux signaux dont on veut visualiser la différence par l'intermédiaire de deux circuits atténuateurs à haute impédance (11, 12) reliés respectivement à deux bornes d'entrée négative et positive (3, 4), caractérisé en ce que l'on déconnecte l'une des entrées (13) de l'étage amplificateur d'entrée (9) et on la relie à la masse, et on agit sur le circuit atténuateur (11) correspondant de manière à maintenir la même impédance d'entrée sur la borne d'entrée correspondante (3).

2. Procédé selon la revendication 1, caractérisé en ce que le mode de fonctionnement est commandé par un organe de commande (7) disposé sur la face avant (10) de l'oscilloscope (1).

3. Procédé selon la revendication 1 ou 2, caractérisé en ce que l'on affiche le mode de fonctionnement sur la face avant (10) de l'oscilloscope (1).

4. Dispositif pour la mise en oeuvre du procédé selon l'une quelconque des revendications 1 à 3, caractérisé en ce qu'il comporte un organe de commande (7) disposé sur la face avant (10) de l'oscilloscope (1) et relié à un circuit de génération d'un signal de commande (15) qui est relié, pour chaque voie, à un circuit de commande (17) relié à un commutateur (14), qui est branché entre une entrée (13) de l'étage amplificateur d'entrée (9) et la sortie de l'un des deux circuits atténuateurs à haute impédance (11), et ledit circuit atténuateur (11).

5. Dispositif selon la revendication 4, caractérisé en ce que le signal de commande est un code numérique.

6. Dispositif selon la revendication 4 ou 5, caractérisé en ce que l'organe de commande est une touche à impulsions (7).

7. Dispositif selon l'une quelconque des revendications 4 à 6, caractérisé en ce qu'il comporte un dispositif d'affichage (8) disposé sur la face avant (10) de l'oscilloscope (1) et relié au circuit de commande (17).
